# FASCICULE DE BREVET EUROPEEN

(11) **EP 1 589 572 B1**
(45) Date de publication et mention de la délivrance du brevet: **11.03.2020**
(21) Numéro de dépôt: 05290791.2
(22) Date de dépôt: 11.04.2005
(51) Int. Cl.: H01L 21/764

(54) **Procédé de fabrication d'un circuit intégré comprenant l'élaboration de tranchées d'isolation creuses**
Verfahren zur Herstellung einer integrierten Schaltung mit einem Isolationsgraben
Process of making an integrated circuit comprising hollow trench isolation

(30) Priorité: 21.04.2004 FR 0404222
(43) Date de publication de la demande: 26.10.2005
(73) Titulaire: NXP B.V., 5656 AG Eindhoven (NL)
(72) Inventeur: Martin, Alexandre, 38920 Crolles (FR); Villanueva, Davy, 38320 Eybens (FR); Salvetti, Frédéric, 38610 Gieres (FR)
(74) Mandataire: Bradler, Carola Romana

(56) Documents cités:
- EP-A- 1 396 882
- EP-A- 1 480 266
- US-A- 4 888 300
- US-A- 5 531 121

## Description

La présente invention concerne les circuits intégrés, plus particulièrement comprenant l'élaboration de tranchées d'isolation creuses.

Un circuit intégré comprend généralement des composants actifs, par exemple des transistors, mutuellement séparés par des zones d'isolation, par exemple des tranchées d'isolation profondes (DTI : Deep Trench Isolation) ou peu profondes (STI : Shallow Trench Isolation). L'air étant un très bon isolant électrique, les tranchées d'isolation sont avantageusement creuses.

Les techniques couramment utilisées pour la fabrication d'un circuit intégré comprenant des tranchées d'isolation creuses consistent généralement en la réalisation complète des tranchées d'isolation creuses avant la réalisation des dispositifs actifs.

Plus précisément, selon ces procédés connus, on grave la tranchée puis on rebouche son ouverture par exemple par un dépôt conforme d'une couche d'oxyde. Cela étant, afin d'éviter un remplissage plus ou moins complet de la tranchée lors de l'opération de rebouchage, il est nécessaire que l'ouverture de la tranchée ne soit pas trop importante. Par conséquent, on ne peut obtenir avec ces procédés de l'art antérieur, que des tranchées étroites présentant par conséquent un volume d'air réduit.

Le document US 5.5311.21 présente un procédé de fabrication de composants micro-usinés tels que par exemple des capteurs permettant de diminuer le nombre d'étapes de fabrication. Les capteurs micro-usinés utilisent des éléments tels que des structures en forme de pont, poutre ou des structures capacitive. Le procédé permet la fabrication de capteurs sur un même substrat où des circuits de contrôle sont disposés.

Le document US 4.888.300 présente un procédé de fabrication de circuits intégrés comportant des régions semi-conductrices isolées du reste du substrat. Pour ce faire, il est proposé d'entourer les régions semi-conductrices par des tranchées gravées dans le substrat.

L'invention vise à apporter une solution à ce problème.

Un but de la présente invention est d'obtenir des tranchées d'isolation creuses de dimension désirée, et notamment de larges tranchées présentant un volume d'air important.

Un autre but de la présente invention est l'élaboration des tranchées d'isolation creuses en utilisant un matériau de remplissage permettant d'utiliser les schémas et procédés classiques pour la réalisation des matériaux de grilles et des contacts associés.

La présente invention permet aussi d'obtenir des tranchées d'isolation creuses entre dispositifs actifs offrant une diminution des effets de couplage électrostatique grâce à la permittivité des gaz enfermés dans les tranchées (air ou vide par exemple), c'est-à-dire une diminution des fuites liées à l'apparition de canaux de conductions parasites le long des tranchées.

Les tranchées selon la présente invention offrent également avantageusement une relaxation des contraintes mécaniques dans les zones actives induites par les étapes technologiques classiques de réalisation de tranchées.

La présente invention propose donc un procédé de fabrication d'un circuit intégré comprenant l'élaboration de tranchées creuses isolantes au sein d'un substrat et la réalisation de composants actifs dans et sur les zones actives du substrat disposées entre lesdites tranchées.

Selon une caractéristique générale de l'invention, l'élaboration des tranchées comprend :
- une phase initiale effectuée avant la réalisation des composants actifs et comportant la formation des tranchées dans le substrat et un remplissage des tranchées avec un matériau de remplissage, et
- une phase finale effectuée après réalisation des composants actifs et comportant une encapsulation des composants actifs, l'aménagement à travers le matériau d'encapsulation d'un accès à chaque tranchée remplies, le retrait du matériau de remplissage à travers chaque accès et le rebouchage de l'ouverture de chaque tranchée à travers l'accès correspondant.

La combinaison d'une élaboration des tranchées en deux phases avec l'utilisation de la couche d'encapsulation des composants pour ménager un accès à la tranchée en vue de la vider puis de reboucher son ouverture permet de définir un facteur de forme souhaité autorisant le rebouchage de tranchées de dimensions quelconques, en particulier de larges tranchées, tout en préservant un large volume d'air par exemple.

Le procédé selon l'invention permet donc d'obtenir des circuits intégrés comprenant des tranchées d'isolation creuses de dimension désirée présentant des propriétés isolantes améliorées.

Selon un mode de réalisation de l'invention, l'accès à la tranchée est avantageusement un puits plus étroit que la partie supérieure de la tranchée, et le rebouchage de l'ouverture de la tranchée comporte par exemple le dépôt conforme d'un matériau de rebouchage dans le puits.

Selon un second mode de réalisation de l'invention, le matériau de remplissage est de préférence un matériau sélectivement éliminable par rapport au matériau du substrat et au matériau d'encapsulation, et le retrait dudit matériau de remplissage comprend par exemple une gravure sélective du matériau de remplissage.

Selon un troisième mode de réalisation de l'invention, le matériau de remplissage peut être le germanium (Ge) ou un alliage de silicium-germanium (Si-Ge). Selon un quatrième mode de réalisation de l'invention, certaines au moins des tranchées peuvent être des tranchées peu profondes, ou bien des tranchées profondes.

D'autres avantages et caractéristiques de l'invention apparaîtront à l'examen de la description détaillée de modes de réalisation et de mise en œuvre, nullement limitatifs, et des dessins annexés, sur lesquels :
- les figures 1 et 2 représentent schématiquement un circuit intégré selon la présente invention ; et
- les figures 3 à 13 illustrent schématiquement les principales étapes d'un procédé selon la présente invention.

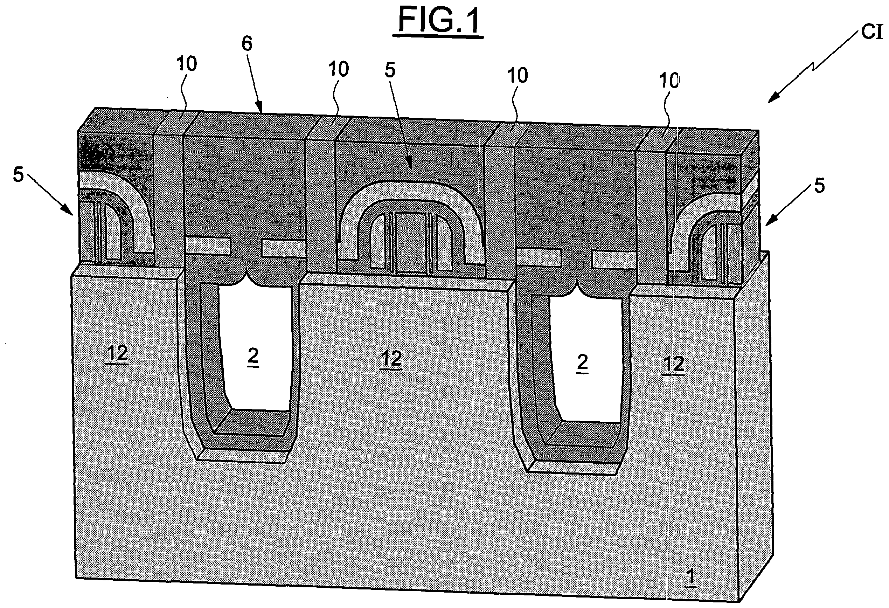

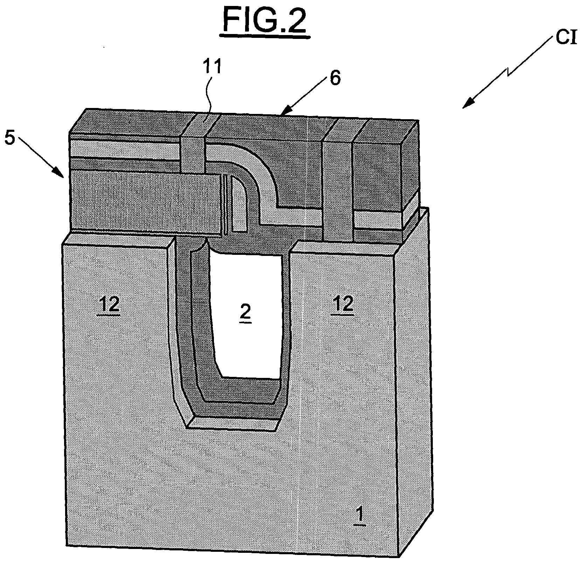

Sur les figures 1 et 2, on a représenté un circuit intégré CI comportant des composants actifs, tels que des transistors MOS mutuellement isolés par des tranchées d'isolation creuses.

Les Figures 1 et 2 représentent respectivement une vue suivant la longueur et la largeur des transistors.

Le circuit intégré comporte un substrat 1, dans lequel les tranchées creuses 2 ont été réalisées entre les zones actives 12 du substrat.

Les transistors 5 ont été réalisés dans et sur les zones actives du substrat. Lesdits dispositifs actifs sont encapsulés par une couche d'encapsulation 6 qui rebouche également l'ouverture des tranchées.

Des contacts drain/source 10 ont été réalisés dans la couche d'encapsulation 6. De même, sur la figure 2, un contact de grille 11 a été réalisé dans la couche d'encapsulation 6.

On va maintenant décrire plus en détails, les principales étapes d'un mode de mise en œuvre du procédé selon l'invention, permettant d'obtenir le circuit intégré des figures 1 et 2.

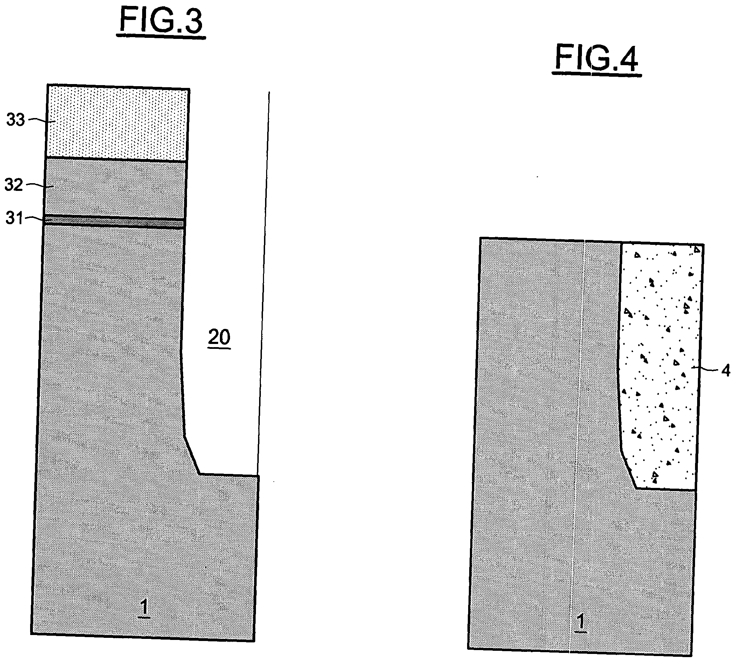

Les figures 3 à 6 illustrent à des fins de simplification, une demi-tranchée et un demi-transistor, étant bien entendu que ces figures présentent un axe de symétrie vertical.

Sur la figure 3, on forme sur le substrat 1, par exemple en silicium, une couche d'oxyde de silicium SiO₂ 31 surmontée d'une couche de nitrure de silicium Si₃N₄ 32. Puis on dépose un masque de résine 33 dans lequel on ménage une ouverture correspondant à l'ouverture de la tranchée.

Puis on grave, de façon connue en soi, les couches 32 et 31. La tranchée 20 est ensuite gravée, de façon connue en soi, par exemple par gravure chimique ou plasma.

Dans le cas d'une tranchée de type STI, la profondeur de la tranchée 20 est par exemple de l'ordre de 0,3 µm, tandis qu'elle est de l'ordre de 5 µm pour une tranchée de type DTI.

La tranchée est ensuite remplie (figure 4) avec un matériau de remplissage 4. Ce materiau est par exemple un materiau séléctivement éliminable par rapport au substrat et aux autres matériaux utilisés dans la fabrication du circuit intégré, tels que les matériaux d'encapsulation. Des exemples de matériaux sélectivement éliminables incluent le germanium (Ge) et les alliages silicium-germanium (SiGe).

On peut citer les alliages Si₁₋ₓGeₓ où 0 < x <1 et les alliages Si₁₋ₓGeₓC_{y} où 0< x ≤0,95 et 0<y≤0,5. De préférence, les alliages SiGe ont un taux relativement élevé de germanium (x ≥0,1 ; de préférence 0,1≤ x ≤0,3) pour une meilleure sélectivité de gravure par rapport au silicium et à SiO₂.

Dans cet exemple de mise en œuvre, le matériau de remplissage remplit la tranchée par dépôt, par exemple du type TEOS. Cela étant une épitaxie est également possible.

Tout excès de matériau (SiGe, nitrure de silicium ...) est éliminé par gravure, et la surface du substrat subit éventuellement une étape de polissage mécano-chimique.

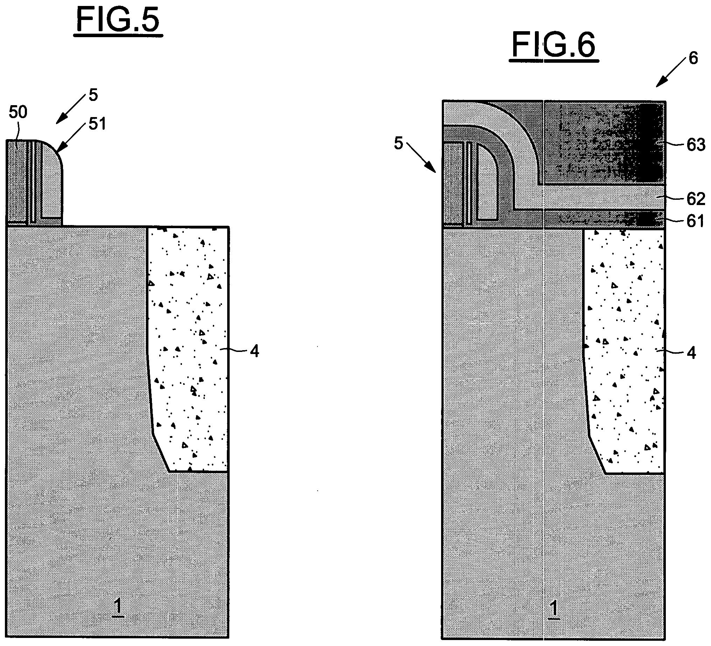

Le remplissage de la tranchée est suivi par la réalisation des composants actifs 5, illustrée par la figure 5, selon des étapes classiques de fabrication connues en soi.

Sur la figure 5, on a aussi illustré partiellement la grille isolée 50 du transistor 5 flanquée d'espaceurs isolants 51, ici multicouches (SiO₂, Si₃N₄).

Une encapsulation de transistor (figure 6) est ensuite effectuée de façon connue. Cette encapsulation peut être réalisée par exemple par dépôt d'une triple couche 6, c'est-à-dire comprenant une première couche d'oxyde SiO₂ 61, une seconde de nitrure Si₃N₄ 62 et une troisième d'oxyde SiO₂ 63. Cette étape est suivie d'un polissage mécano-chimique de la surface du circuit.

On réalise ensuite un puits 64 dans la couche d'encapsulation 6 de façon à accéder à la surface supérieure de la tranchée 20 remplie avec le matériau de remplissage 4.

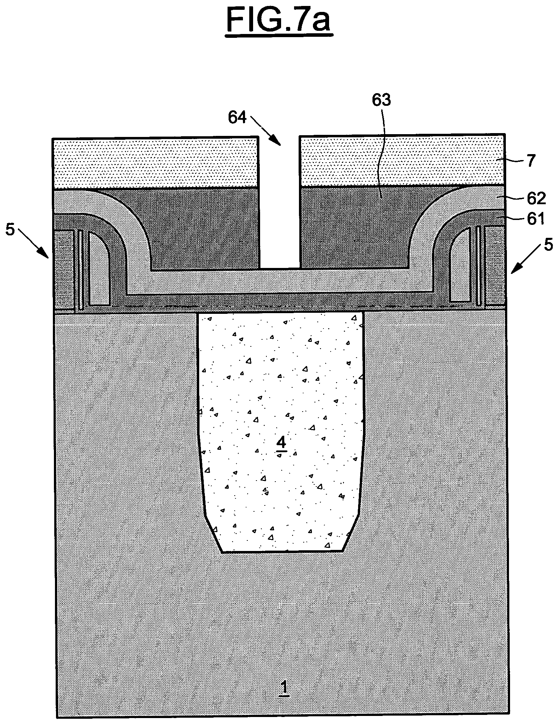

Comme illustré sur la figure 7a, on grave ce puits 64 en utilisant un masque de résine 63 qui permet de définir les dimensions de l'orifice du puits. La gravure s'effectue par des gravures successives connues en soi jusqu'à atteindre le matériau de remplissage 4.

Les proportions du puits sont déterminées en fonction de l'épaisseur de la couche d'encapsulation et des dimensions de la tranchée d'isolation afin d'obtenir un facteur de forme désiré. Ce puits sera en général de préférence plus étroit que la partie supérieure (ouverture) de la tranchée et sa hauteur est de préférence au moins deux fois sa largeur afin d'éviter la création de bulle d'air lors de l'étape de remplissage ultérieur.

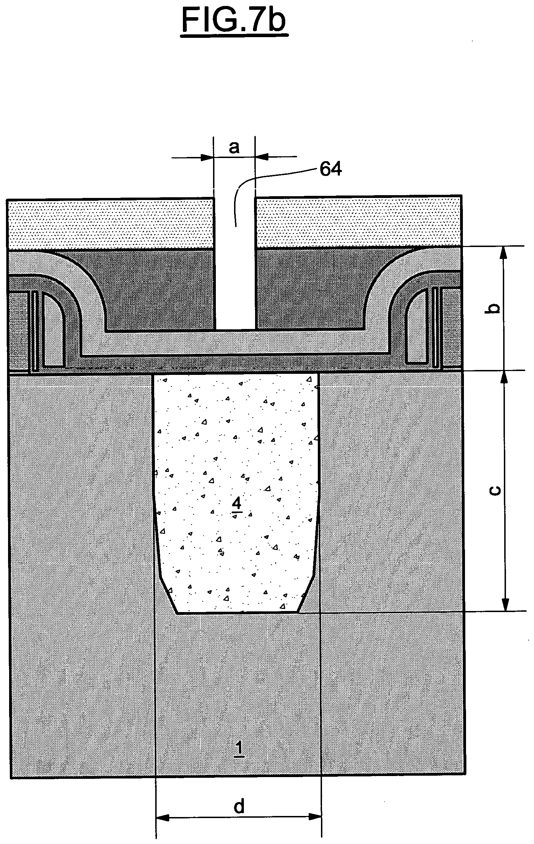

La Figure 7b représente une tranchée dite peu profonde (STI). La profondeur c de la tranchée est de 0,30 µm et sa largeur est de 0,21 µm. Pour une couche d'encapsulation d'épaisseur b égale à 0,20 µm, on choisira par exemple un puits d'un largeur comprise entre 0,10 à 0,15 µm.

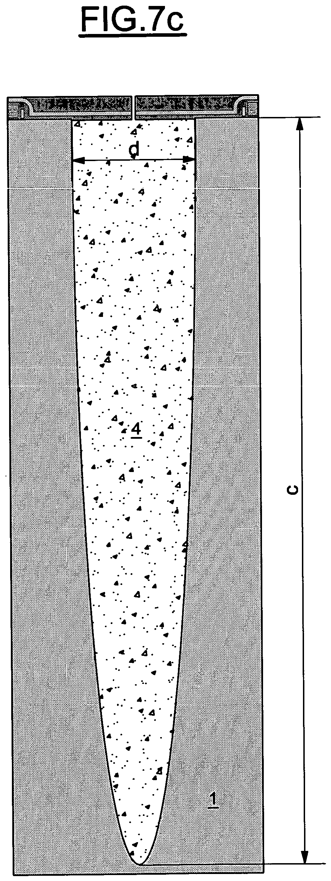

On pourra ensuite choisir un puits identique pour le cas d'une tranchée profonde (DTI) telle qu'illustrée sur la figure 7c, et pour laquelle d = 0,80 µm et c = 5 µm.

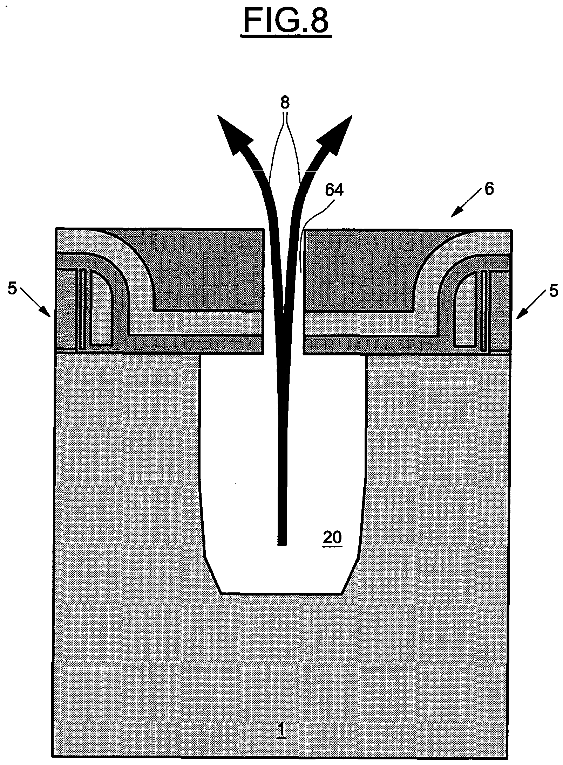

Une fois le puits d'accès 8 réalisé, le matériau de remplissage 4 est retiré (figure 8) de la tranchée à travers ledit puits d'accès. Ce retrait 8 est effectué par gravure sélective du matériau de remplissage 4.

L'élimination sélective du germanium ou de l'alliage SiGe peut se faire par tout procédé connu, par exemple au moyen d'une chimie oxydante telle qu'une solution 40 ml HNO₃ 70 % + 20 ml H₂O₂ + 5 ml HF 0,5 % ou par attaque plasma isotrope.

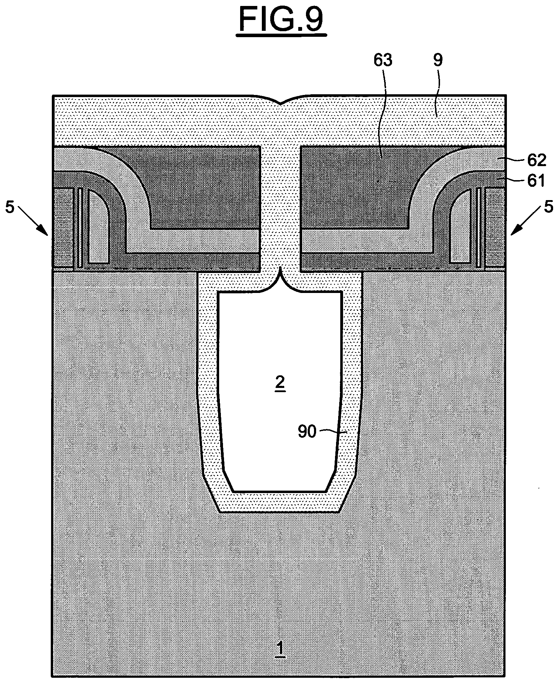

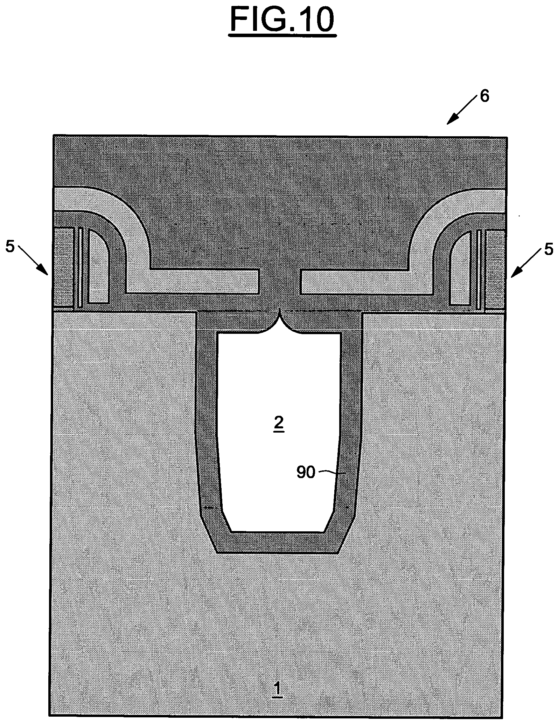

Le puits d'accès est ensuite rebouché (figure 9). Le rebouchage peut être obtenu par un dépôt conforme d'un matériau de rebouchage (9) dans le puits, par exemple du SiO₂ identique au SiO₂ 63 de la couche d'encapsulation 6. Avantageusement, l'épaisseur de ce dépôt conforme vaut la demi-largeur du puits d'accès 8. Le rebouchage du puits est suivi d'une étape de polissage mécano-chimique (figure 10) de la surface du circuit.

Lors du dépôt conforme le puits se remplit progressivement et une couche 90 de matériau de rebouchage se dépose sur les flancs de la tranchée 2. Puis l'ouverture de la tranchée se bouche ainsi que le puits.

Ainsi quelle que soit la dimension de la tranchée, c'est le puits d'accès qui définit l'ouverture de la tranchée à reboucher, et c'est grâce à ce puits que l'on peut reboucher l'ouverture de la tranchée sans déposer trop de matériau à l'intérieur de la tranchée et préserver ainsi un volume d'air suffisant, et ce quelle que soit la taille de la tranchée.

Bien entendu, l'homme du métier saura choisir les dimensions du puits en fonction de celles de la tranchée et de la couche d'encapsulation de façon à obtenir le résultat souhaité.

On remarquera également que, dans la première phase, le matériau de remplissage 4 de la tranchée sert d'appui pour le dépôt de la couche d'encapsulation, cette dernière gardant alors sa cohérence lors de la gravure du puits. Et ce puits permet à la fois le retrait du matériau de remplissage pour retrouver la tranchée creuse puis l'obturation de la tranchée creuse.

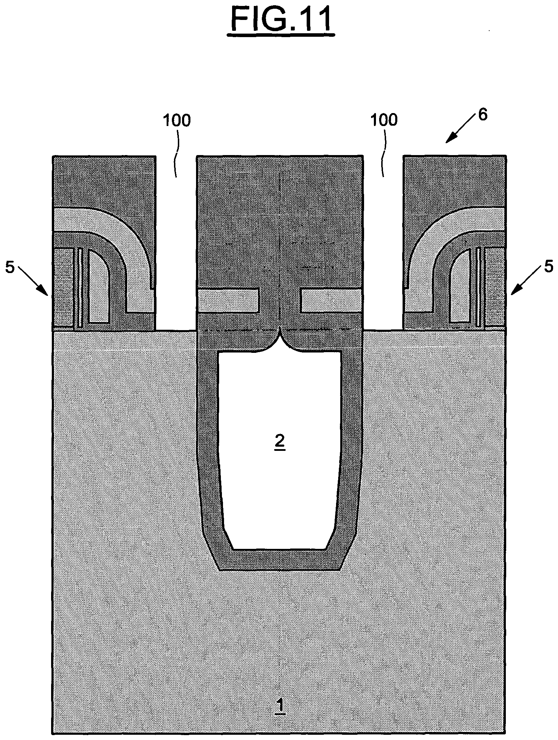

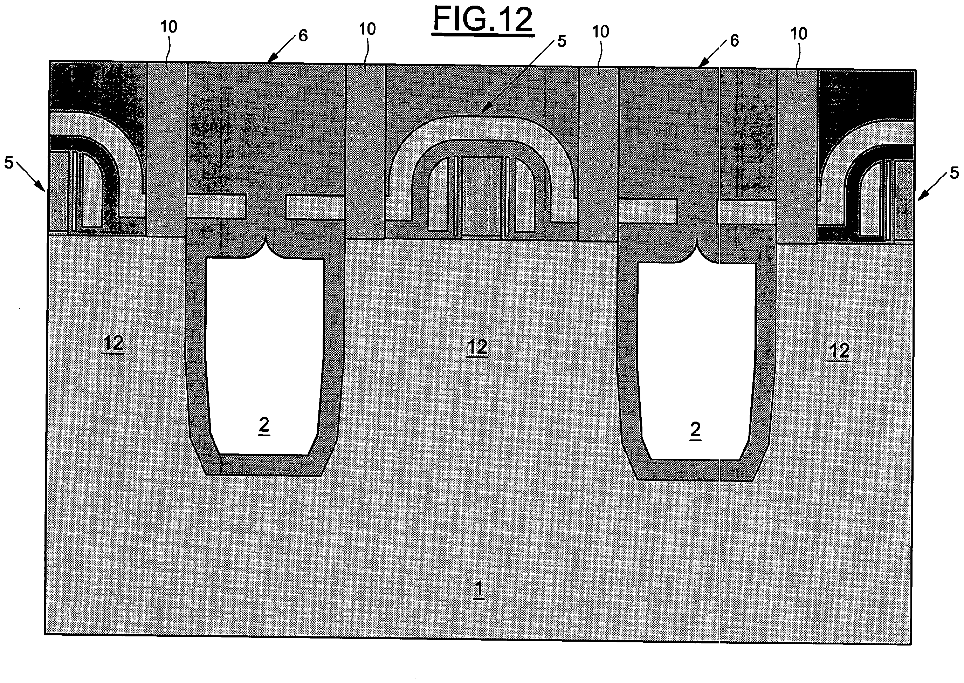

La figure 11 représente une vue en longueur du circuit sur lequel on effectue ensuite une gravure des emplacements 100 des contacts drain/source dans la couche d'encapsulation. Ces emplacements sont ensuite remplis d'un métal pour former les contacts drain/source 10 (figure 12).

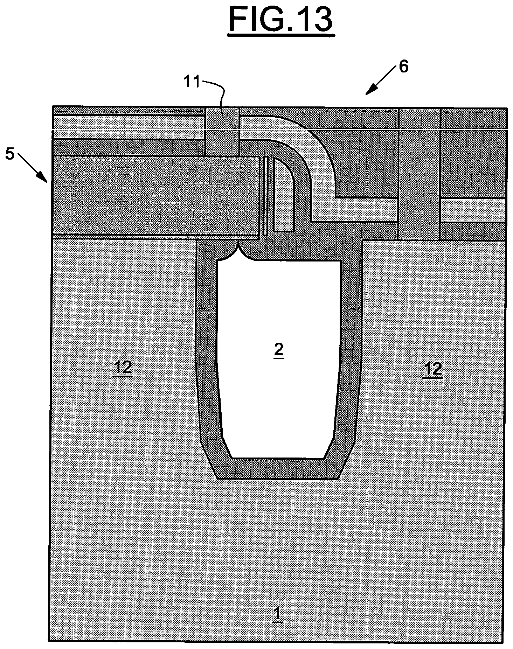

De la même manière, la figure 13 représente une vue en largeur du circuit sur lequel on effectue la gravure ou photogravure des contacts grille, lesdits contacts grille 11 étant ensuite remplis d'un métal.

## Revendications

1. Procédé de fabrication d'un circuit intégré (CI) comprenant des tranchées creuses isolantes dans un substrat et des composants actifs dans et sur des zones actives du substrat disposées entre lesdites tranchées, ledit procédé comprenant :
- l'élaboration de tranchées creuses isolantes (2) au sein d'un substrat (1) et
- la réalisation de composants actifs (5) dans et sur les zones actives (12) du substrat disposées entre lesdites tranchées (2),
dans lequel:
- l'élaboration des tranchées (2) comprend :
- une phase initiale effectuée avant la réalisation des composants actifs (5) et comportant :
* la formation de tranchées (2) dans le substrat (1), et
* un remplissage des tranchées (2) avec un matériau de remplissage (4), et
- une phase finale effectuée après réalisation des composants actifs (5) et comportant :
*une encapsulation (6) des composants actifs (5),
* l'aménagement à travers le matériau d'encapsulation (6) d'un puits d'accès (64) à chaque tranchée remplie,
* le retrait du matériau de remplissage (4) des tranchées à travers chaque puits, et
* le rebouchage de l'ouverture de chaque tranchée à travers le puits d'accès (64) correspondant, des tranchées creuses isolantes étant ainsi formées.

2. Procédé selon la revendication 1, dans lequel: le puits d'accès à la tranchée (2) est plus étroit que la partie supérieure de la tranchée et dans lequel le rebouchage de l'ouverture de la tranchée (2) comporte le dépôt conforme d'un matériau de rebouchage (9) dans le puits (64).

3. Procédé selon la revendication 1 ou 2, dans lequel:
- le matériau de remplissage (4) est un matériau sélectivement éliminable par rapport au matériau du substrat (1) et au matériau d'encapsulation (6), et
- le retrait (8) dudit matériau de remplissage (4) comprend une gravure sélective du matériau de remplissage (4).

4. Procédé selon l'une quelconque des revendications 1 à 3, dans lequel: le matériau de remplissage (4) est le germanium ou un alliage de silicium-germanium.

5. Procédé selon l'une quelconque des revendications 1 à 4, dans lequel: certaines au moins des tranchées (2) sont des tranchées peu profondes.

6. Procédé selon l'une quelconque des revendications 1 à 5, dans lequel: certaines au moins des tranchées (2) sont des tranchées profondes.

## Patentansprüche

1. Verfahren zur Herstellung einer integrierten Schaltung (CI), welche hohle Isolationsgräben in einem Substrat und aktive Komponenten in und auf aktiven Bereichen des Substrats, die zwischen den Gräben angeordnet sind, umfasst, wobei das Verfahren umfasst:
- die Ausbildung von hohlen Isolationsgräben (2) innerhalb eines Substrats (1) und
- die Realisierung von aktiven Komponenten (5) in und auf den aktiven Bereichen (12) des Substrats, die zwischen den Gräben (2) angeordnet sind,
wobei:
- die Ausbildung der Gräben (2) umfasst:
- eine Anfangsphase, die vor der Realisierung der aktiven Komponenten (5) durchgeführt wird und aufweist:
* die Bildung von Gräben (2) in dem Substrat (1) und
* ein Füllen der Gräben (2) mit einem Füllmaterial (4) und
- eine Endphase, die nach Realisierung der aktiven Komponenten (5) durchgeführt wird und aufweist:
* eine Kapselung (6) der aktiven Komponenten (5),
* die Einrichtung, durch das Kapselungsmaterial (6) hindurch, eines Zugangsloches (64) zu jedem gefüllten Graben,
* die Entnahme des Füllmaterials (4) aus den Gräben durch jedes Zugangsloch hindurch, und
* das erneute Verschließen der Öffnung jedes Grabens durch das entsprechende Zugangsloch (64) hindurch, wobei auf diese Weise hohle Isolationsgräben gebildet werden.

2. Verfahren nach Anspruch 1, wobei:
das Zugangsloch zu dem Graben (2) enger als der obere Teil des Grabens ist, und wobei das erneute Verschließen der Öffnung des Grabens (2) die konforme Ablagerung eines Verschlussmaterials (9) in dem Loch (64) umfasst.

3. Verfahren nach Anspruch 1 oder 2, wobei:
- das Füllmaterial (4) ein in Bezug auf das Material des Substrats (1) und auf das Kapselungsmaterial (6) selektiv entfernbares Material ist, und
- die Entnahme (8) des Füllmaterials (4) eine selektive Ätzung des Füllmaterials (4) umfasst.

4. Verfahren nach einem der Ansprüche 1 bis 3, wobei das Füllmaterial (4) Germanium oder eine Silizium-Germanium-Legierung ist.

5. Verfahren nach einem der Ansprüche 1 bis 4, wobei wenigstens einige der Gräben (2) Gräben von geringer Tiefe sind.

6. Verfahren nach einem der Ansprüche 1 bis 5, wobei wenigstens einige der Gräben (2) tiefe Gräben sind.

## Claims

1. Process for fabricating an integrated circuit (CI) comprising hollow trench isolations in a substrate and active components in and on active zones of the substrate, these zones being arranged between said trench isolations, said process comprising:
- forming hollow trench isolations (2) within a substrate (1); and
- producing active components (5) in and on the active zones (12) of the substrate, these zones being arranged between said trench isolations (2), wherein:
- the operation of forming the trench isolations (2) comprises:
- an initial phase carried out before the operation of producing the active components (5) and including:
* an operation of forming trench isolations (2) in the substrate (1); and
* an operation of filling the trench isolations (2) with a filler material (4); and
- a final phase carried out before the operation of producing the active components (5) and including:
* an operation of encapsulating (6) the active components (5);
* an operation of making an access well (64) through the encapsulation material (6) to each filled trench isolation;
* an operation of removing the filler material (4) from the trench isolations through each well; and
* an operation of filling in the opening in each trench isolation through the corresponding access well (64), hollow trench isolations thus being formed.

2. Process according to Claim 1, wherein: the access well to the trench isolation (2) is narrower than the upper portion of the trench isolation and wherein the operation of filling in the opening in the trench isolation (2) includes the conformal deposition of an infill material (9) in the well (64).

3. Process according to Claim 1 or 2, wherein:
- the filler material (4) is a material that can be removed selectively with respect to the material of the substrate (1) and to the encapsulation material (6); and
- the operation of removing (8) said filler material (4) comprises an operation of selectively etching the filler material (4).

4. Process according to any one of Claims 1 to 3, wherein: the filler material (4) is germanium or a silicon-germanium alloy.

5. Process according to any one of Claims 1 to 4, wherein: at least some of the trench isolations (2) are shallow trench isolations.

6. Process according to any one of Claims 1 to 5, wherein: at least some of the trench isolations (2) are deep trench isolations.
